# EUROPEAN PATENT SPECIFICATION

(11) **EP 4 080 582 B1**
(45) Date of publication and mention of the grant of the patent: **24.04.2024**
(21) Application number: 22169177.7
(22) Date of filing: 21.04.2022
(51) Int. Cl.: H01L 29/778, H01L 29/417, H01L 29/06, H01L 29/20

(54) **GALLIUM NITRIDE DEVICE, SWITCHING POWER TRANSISTOR, DRIVE CIRCUIT, AND GALLIUM NITRIDE DEVICE PRODUCTION METHOD**
GALLIUMNITRIDVORRICHTUNG, SCHALTLEISTUNGSTRANSISTOR, TREIBERSCHALTUNG UND VERFAHREN ZUR HERSTELLUNG EINER GALLIUMNITRIDVORRICHTUNG
DISPOSITIF DE NITRURE DE GALLIUM, TRANSISTOR DE PUISSANCE DE COMMUTATION, CIRCUIT DE COMMANDE ET PROCÉDÉ DE PRODUCTION DE DISPOSITIF DE NITRURE DE GALLIUM

(30) Priority: 22.04.2021 CN 202110436275
(43) Date of publication of application: 26.10.2022
(73) Proprietor: Huawei Technologies Co., Ltd., Longgang District Shenzhen, Guangdong 518129 (CN)
(72) Inventor: BAO, Qilong, Shenzhen, 518129 (CN); JIANG, Qimeng, Shenzhen, 518129 (CN); TANG, Gaofei, Shenzhen, 518129 (CN); WANG, Hanxing, Shenzhen, 518129 (CN); HUANG, Boning, Shenzhen, 518129 (CN); HOU, Zhaozheng, Shenzhen, 518129 (CN)
(74) Representative: Epping - Hermann - Fischer

(56) References cited:
- CN-A- 112 531 020
- US-A1- 2011 215 379

## Description

### TECHNICAL FIELD

This application relates to the field of semiconductor technologies, and in particular, to a gallium nitride device, a switching power transistor, a drive circuit, and a gallium nitride device production method.

### BACKGROUND

As requirements for low energy consumption, high efficiency, and high power density of a semiconductor device currently become increasingly obvious in the industry, a gallium nitride device (for example, a switching device such as a field effect transistor) produced based on gallium nitride has attracted increasing attention.

Currently, the gallium nitride device mainly includes a device that is based on an aluminum gallium nitride/gallium nitride (AlGaN/GaN) lateral heterostructure. Because the AlGaN/GaN heterostructure has a high two-dimensional electronic gas 2DEG channel at an interface of the AlGaN/GaN heterostructure, a two-dimensional electronic gas (two-dimensional electronic gas, 2DEG) channel with high electron mobility can be naturally formed at the interface of the AlGaN/GaN heterostructure. Therefore, compared with a semiconductor silicon device, the gallium nitride device has lower energy consumption, higher efficiency, and higher power density.

However, a gallium nitride device produced based on a current production process usually has some deficiencies. These deficiencies may lead to a "current collapse" effect in the gallium nitride device. The "current collapse" effect herein means an increase in an on-resistance of the gallium nitride device, which reduces a switching speed of the gallium nitride device, increases a driving loss, and reduces reliability of the device.

CN112531020A discloses a nitride power device with a composite drain structure, which comprises a GaN channel layer, an AlGaN barrier layer, source metal, drain metal and grid metal, wherein the channel layer and the barrier layer form a heterojunction, and the source metal, the drain metal and the grid metal are arranged on the barrier layer; the p-type nitride structure is arranged between the drain metal and the barrier layer and is separately arranged at intervals, and the drain metal and the p-type nitride structure form ohmic contact.

US20110215379A1 discloses a field effect transistor including a semiconductor stack formed on a substrate, and having a first nitride semiconductor layer and a second nitride semiconductor layer. A source electrode and a drain electrode are formed on the semiconductor stack so as to be separated from each other. A gate electrode is formed between the source electrode and the drain electrode so as to be separated from the source electrode and the drain electrode. A hole injection portion is formed near the drain electrode. The hole injection portion has a p-type third nitride semiconductor layer, and a hole injection electrode formed on the third nitride semiconductor layer. The hole injection electrode and the drain electrode have substantially the same potential.

### SUMMARY

Embodiments of this application provide a gallium nitride device production method as defined in the claims, to avoid an increase in an intrinsic on-resistance of the device while ensuring efficiency of hole injection at P-GaN, thereby increasing a switching speed of the device, reducing a driving loss of the device, and improving reliability of the device. The embodiments or aspects which are not directed to the gallium nitride device production method are not presented as embodiments of the invention, but as examples useful for understanding the invention.

According to a first aspect, an embodiment of this application provides a gallium nitride device which can be manufactured according to the invention. The gallium nitride device includes: a substrate; a buffer layer formed over the substrate; a gallium nitride GaN layer formed over the buffer layer; an AlGaN layer formed over the gallium nitride GaN layer; and a source, a drain, and a gate that are formed on the AlGaN layer. The drain includes a P-GaN layer and a drain metal. The P-GaN layer is formed on the AlGaN layer by etching the P-GaN layer on the AlGaN layer, and is of a strip structure in a gate width direction of the device. The drain metal includes a plurality of first structural intervals and a plurality of second structural intervals. The plurality of first structural intervals and the plurality of second structural intervals are alternately distributed in the gate width direction. In the first structural intervals, the drain metal is in contact with the P-GaN layer but not with the AIGaN layer; and in the second structural intervals, the drain metal is in contact with the P-GaN layer and forms ohmic contact with the AlGaN layer.

According to the foregoing technical solution, the drain metal is in contact with the P-GaN layer in the first structural intervals, implementing local injection of holes; and the drain metal forms ohmic contact with the AlGaN layer in the second structural intervals, implementing current conduction from the drain to the source of the device. Therefore, while efficiency of hole injection at P-GaN is ensured, the device does not have an excessively large intrinsic on-resistance, thereby increasing a switching speed of the device, reducing a driving loss of the device, and improving reliability of the device. In addition, when the gallium nitride device is produced, the P-GaN layer does not need to be etched into a discontinuous structure, thereby avoiding an impact of etching precision on performance of the device, and allowing a simpler process.

With reference to the first aspect, in a first possible implementation of the first aspect, in the first structural intervals, the drain metal is formed on the P-GaN layer, and a width of the drain metal in a direction perpendicular to the gate width direction in a direction perpendicular to the gate width direction is less than or equal to a width of the P-GaN layer. In this way, the P-GaN layer can isolate the drain metal from the AlGaN layer, so that the drain metal is not in contact with the AlGaN layer. Therefore, electrons of the drain metal are not injected into the AlGaN layer that is under the drain metal, and in the device, local holes are formed under the drain metal, implementing local injection of holes for the device. The local holes can compensate for a negative electron trap, so that electrons captured by the electron trap are released, avoiding a "current collapse" effect.

With reference to the first aspect, in a second possible implementation of the first aspect, in the first structural intervals, the drain metal is formed on the P-GaN layer; a width of the drain metal in a direction perpendicular to the gate width direction is greater than a width of the P-GaN layer; the drain metal includes extension portions located on two sides of the P-GaN layer; and the extension portions are isolated from the AlGaN layer by passivation layers. In this way, although the width of the drain metal is greater than the width of the P-GaN layer, the drain metal is not in contact with the AlGaN layer due to the passivation layers. Therefore, electrons of the drain metal are not injected into the AlGaN layer that is under the drain metal, and in the device, local holes are formed under the drain metal, implementing local injection of holes for the device. The local holes can compensate for a negative electron trap, so that electrons captured by the electron trap are released, avoiding a "current collapse" effect.

With reference to the first aspect and the first and second possible implementations of the first aspect, in a third possible implementation of the first aspect, in the second structural intervals, the drain metal is formed on the P-GaN layer and the AlGaN layer; the width of the drain metal is greater than the width of the P-GaN layer; the drain metal includes the extension portions located on the two sides of the P-GaN layer; and the extension portions form ohmic contact with the AlGaN layer. In this way, because the width of the drain metal is greater than the width of the P-GaN layer, the drain metal located outside a width range of the P-GaN layer can form ohmic contact with the AlGaN layer, implementing current conduction from the drain to the source of the device.

With reference to the first aspect and the first to third possible implementations of the first aspect, in a fourth possible implementation of the first aspect, the P-GaN layer has a same width in all positions in the gate width direction. In this way, when the P-GaN layer is etched, it is not necessary to control etching precision in each position of the P-GaN layer for different widths, thereby reducing a difficulty of a process.

With reference to the third possible implementation of the first aspect, in a fifth possible implementation of the first aspect, the drain metal has a same width in all positions in the gate width direction. In this way, when the drain metal is etched, it is not necessary to control etching precision in each position of the P-GaN layer for different widths, thereby reducing a difficulty of a process.

With reference to the first aspect and the first to fifth possible implementations of the first aspect, in a sixth possible implementation of the first aspect, the plurality of first structural intervals and the plurality of second structural intervals are an integrated structure. In this way, when the drain metal is etched, it is not necessary to control etching spacing between the first structural interval and the second structural interval, to reduce the difficulty of the process. With reference to the first aspect and the first to fifth possible implementations of the first aspect, in a seventh possible implementation of the first aspect, the plurality of first structural intervals and the plurality of second structural intervals are alternately distributed in the gate width direction, and there is specific spacing between a first structural interval and a second structural interval that are adjacent.

According to a second aspect, an embodiment of this application provides a gallium nitride device production method according to the invention.

The method is used for producing the gallium nitride device according to the first embodiment and the implementations of the first embodiment in this application. The method includes: epitaxially growing the buffer layer, the GaN layer, and the AlGaN layer sequentially from bottom to top on the substrate; etching the P-GaN layer on the AlGaN layer, where the P-GaN layer is of the continuous strip structure in the gate width direction; and producing the drain metal on the P-GaN layer and the AlGaN layer that is located on two sides of the P-GaN layer, so that the drain metal has the plurality of first structural intervals and the plurality of second structural intervals that are alternately distributed in the gate width direction.

According to the foregoing technical solution, the drain metal is in contact with the P-GaN layer in the first structural intervals, implementing local injection of holes; and the drain metal forms ohmic contact with the AlGaN layer in the second structural intervals, implementing current conduction from the drain to the source of the device. Therefore, while efficiency of hole injection at P-GaN is ensured, the device does not have an excessively large intrinsic on-resistance, thereby increasing a switching speed of the device, reducing a driving loss of the device, and improving reliability of the device. In addition, when the gallium nitride device is produced, the P-GaN layer does not need to be etched into a discontinuous structure, thereby avoiding an impact of etching precision on performance of the device, and allowing a simpler process.

With reference to the second aspect, in a first possible implementation of the first aspect, the first structural intervals are obtained by using the following method: etching the drain metal on the P-GaN layer, where a width of the drain metal in a direction perpendicular to the gate width direction is less than or equal to a width of the P-GaN layer, to form the first structural intervals. In this way, the P-GaN layer can isolate the drain metal from the AlGaN layer, so that the drain metal is not in contact with the AlGaN layer. Therefore, electrons of the drain metal are not injected into the AlGaN layer that is under the drain metal, and in the device, local holes are formed under the drain metal, implementing local injection of holes for the device. The local holes can compensate for a negative electron trap, so that electrons captured by the electron trap are released, avoiding a "current collapse" effect.

With reference to the second aspect, in a second possible implementation of the first aspect, the second structural intervals are obtained by using the following method: etching the drain metal on the P-GaN layer and the AlGaN layer that is located on the two sides of the P-GaN layer, where the drain metal includes extension portions located on the two sides of the P-GaN layer, and the extension portions form ohmic contact with the AlGaN layer, to form the second structural intervals. In this way, because a width of the drain metal is greater than a width of the P-GaN layer, the drain metal located outside a width range of the P-GaN layer can form ohmic contact with the AlGaN layer, implementing current conduction from the drain to the source of the device.

With reference to the second aspect, in a third possible implementation of the first aspect, the first structural intervals and the second structural intervals are obtained by using the following method: performing etching removal, at intervals in the gate width direction, on passivation layers that are in areas on the two sides of the P-GaN layer; and etching the drain metal on the P-GaN layer and the AlGaN layer that is located on the two sides of the P-GaN layer, where the drain metal includes extension portions located on the two sides of the P-GaN layer, in areas in which the passivation layers are not removed by etching, the extension portions are isolated from the AlGaN layer by the passivation layers, to form the first structural intervals; and in areas in which the passivation layers are removed by etching, the extension portions are in contact with the AlGaN layer, to form the second structural intervals. In this way, in the first structural intervals, the P-GaN layer can isolate the drain metal from the AlGaN layer, so that the drain metal is not in contact with the AlGaN layer. Therefore, electrons of the drain metal are not injected into the AlGaN layer that is under the drain metal, and in the device, local holes are formed under the drain metal, implementing local injection of holes for the device. The local holes can compensate for a negative electron trap, so that electrons captured by the electron trap are released, avoiding a "current collapse" effect. In the second structural intervals, because a width of the drain metal is greater than a width of the P-GaN layer, the drain metal located outside a width range of the P-GaN layer can form ohmic contact with the AlGaN layer, implementing current conduction from the drain to the source of the device.

According to a third aspect, an embodiment of this application provides a drive circuit. The drive circuit includes a gate driver and the gallium nitride device according to the first aspect and the implementations of the first aspect in the embodiments of this application. A gate of the gallium nitride device is coupled to a signal output terminal of the gate driver, and a source and a drain of the gallium nitride device are coupled into a load circuit. The gate driver is configured to output a first potential to turn on the gallium nitride device, and output a second potential to turn off the gallium nitride device, where the first potential is higher than a turn-on potential of the gallium nitride device, and the second potential is lower than the turn-on potential of the gallium nitride device. In this way, the gallium nitride device may be used as a switching device in the load circuit, and is controlled to be on and off by the gate driver. Because the gallium nitride device overcomes a "current collapse" effect and has a small intrinsic on-resistance and a small device loss, overall operating efficiency of the load circuit can be improved, a total amount of heat generated by the load circuit can be reduced, and operating stability of the load circuit can be improved.

### DESCRIPTION OF DRAWINGS

FIG. 1 is a schematic diagram of a section of a common gallium nitride device;
FIG. 2 is a schematic diagram of a section of a gallium nitride device used to suppress a "current collapse" effect;
FIG. 3 is a three-dimensional view of a gallium nitride device used to suppress a "current collapse" effect;
FIG. 4 is a three-dimensional view of a gallium nitride device according to Embodiment 1 of this application which can be manufactured according to the invention;
FIG. 5 is a view of a partial section of a first structural interval in a direction A according to Embodiment 1 of this application;
FIG. 6 is a view of a partial section of a second structural interval in a direction A according to Embodiment 1 of this application;
FIG. 7A, FIG. 7B, and FIG. 7C are a flowchart of a gallium nitride device production method according to Embodiment 2 of this application;
FIG. 8 is a three-dimensional view of a gallium nitride device according to Embodiment 3 of this application which can be manufactured according to the invention;
FIG. 9 is a view of a partial section of a first structural interval according to Embodiment 3 of this application;
FIG. 10 is a view of a partial section of a second structural interval according to Embodiment 3 of this application;
FIG. 11A, FIG. 11B, and FIG. 11C are a flowchart of a gallium nitride device production method according to Embodiment 4 of this application; and
FIG. 12 is a three-dimensional view of a structure of a gallium nitride device according to Embodiment 5 of this application which can be manufactured according to the invention.

Illustration:
100: substrate, 200: buffer layer, 300: GaN layer, 400: AlGaN layer, 410: passivation layer, 500: P-GaN layer, 610: first structural interval, 620: second structural interval, and 621: extension portion.

### DESCRIPTION OF EMBODIMENTS

Gallium nitride (GaN, gallium nitride) is a compound of nitrogen and gallium, and is a direct band gap semiconductor of group III (boron group element) and group V (nitrogen group element). Gallium nitride has a wide band gap of 3.4 eV (electron volt), while silicon, a currently most commonly used semiconductor material, has a band gap of 1.12 eV Therefore, gallium nitride has better performance than a silicon component in high-power and high-speed components. As requirements for low energy consumption, high efficiency, and high power density of a semiconductor device currently become increasingly obvious in the industry, a gallium nitride device (for example, a switching device such as a field effect transistor and a switching power transistor) produced based on gallium nitride has attracted increasing attention. Currently, the gallium nitride device mainly includes a device that is based on an aluminum gallium nitride/gallium nitride (AlGaN/GaN) lateral heterostructure. Because the AlGaN/GaN heterostructure has a high two-dimensional electronic gas 2DEG channel at an interface of the AlGaN/GaN heterostructure, a 2DEG channel with high electron mobility can be naturally formed at the interface of the AlGaN/GaN heterostructure. Therefore, compared with a semiconductor silicon device, the gallium nitride device has lower energy consumption, higher efficiency, and higher power density. In addition, gallium nitride is a wide band gap semiconductor, and has a high operating temperature, which usually can reach at least 500°C. Therefore, the gallium nitride device can operate under high temperature conditions. In addition, gallium nitride further has a high breakdown electric field. Therefore, the gallium nitride device has a high gate-drain breakdown voltage and can operate under high voltage conditions. Although the gallium nitride device meets the industry's requirements for low energy consumption, high efficiency, and high power density of semiconductor devices, a gallium nitride device produced based on a current production process usually has some deficiencies. These deficiencies may lead to a "current collapse" effect in the gallium nitride device. The "current collapse" effect herein means an increase in an on-resistance of the gallium nitride device, which affects operating stability of a system

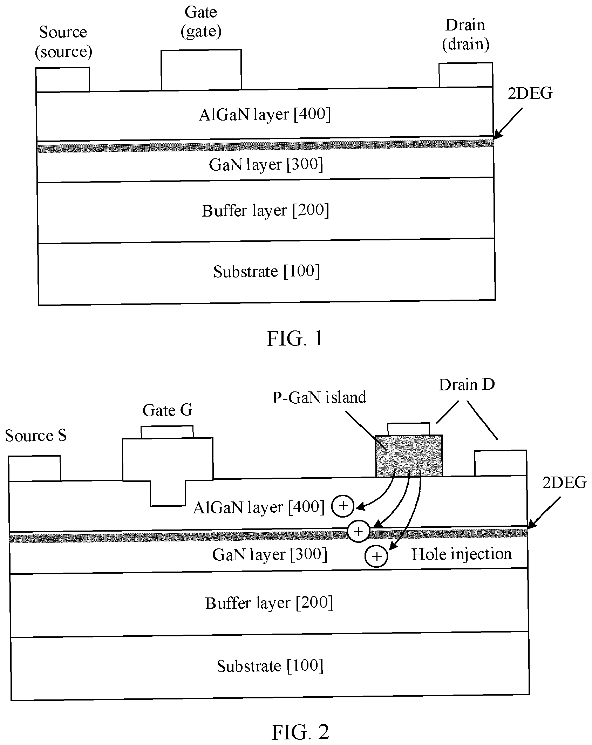

FIG. 1 is a schematic diagram of a section of a common gallium nitride device. The following specifically describes causes of the deficiencies in the gallium nitride device with reference to FIG. 1. As shown in FIG. 1, because the gallium nitride device lacks a self-supporting substrate, the gallium nitride device usually needs to be produced by using an epitaxially growing method. Specifically, first, a buffer layer 200 (buffer layer) may be epitaxially grown over a substrate 100 (which is usually silicon Si); then, a GaN layer 300 may be epitaxially grown over the buffer layer 200; then, an aluminum gallium nitride AlGaN layer 400 may be epitaxially grown over the GaN layer 300, to obtain an aluminum gallium nitride/gallium nitride (AlGaN/GaN) lateral heterostructure; and finally, a source (source, S), a drain (drain, D), and a gate (gate, G) may be produced on the AlGaN layer 400. In this way, the gallium nitride device is produced.

However, because the substrate and the GaN are of different materials and have different lattice constants and different coefficients of thermal expansion, an epitaxial layer has a crack due to problems such as a lattice mismatch and a thermal expansion mismatch between the substrate and the GaN, causing a large quantity of deficiencies in the GaN epitaxial material. These deficiencies capture electrons, resulting in a decrease in a concentration of carriers that are in an operating state in the device, and consequently a "current collapse" effect in the device.

FIG. 2 is a schematic diagram of a section of a gallium nitride device used to suppress a "current collapse" effect. As shown in FIG. 2, currently, a method for suppressing the "current collapse" effect is to introduce a P-type doped gallium nitride P-GaN island structure to a drain D of a GaN device. The P-GaN island structure can implement hole injection in a local area. A hole of positive charges can compensate for a negative electron trap, so that electrons captured by the electron trap are released.

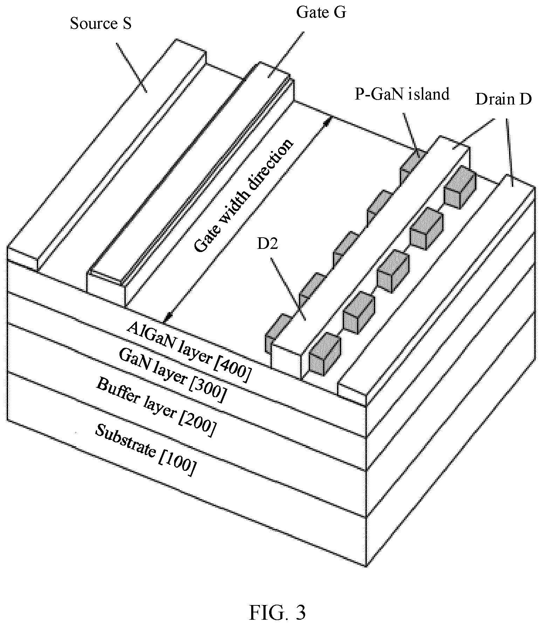

FIG. 3 is a three-dimensional view of a gallium nitride device used to suppress a "current collapse" effect. As shown in FIG. 3, in a gate width direction, the P-GaN island structure may include a drain metal D2 and a plurality of P-GaN islands distributed as islands. The plurality of P-GaN islands are distributed at intervals in the gate width direction, and the drain metal D2 is continuously distributed in the gate width direction. In areas in which the P-GaN islands are distributed, the drain metal D2 grows on the P-GaN islands, to implement local hole injection. In areas in which no P-GaN island is distributed, the drain metal D2 grows on an AlGaN layer. In this way, when the plurality of P-GaN islands are distributed at intervals, a substantial increase in an intrinsic on-resistance of the device can be avoided without causing a substantial loss of chip performance.

However, in actual production, the discontinuous structure of the P-GaN islands needs to be obtained through etching, and design of a spacing distance and etching precisionboth affect a spacing distance between produced P-GaN islands. Therefore, the spacing distance between the P-GaN islands is quite difficult to control. An excessively large spacing distance results in a decrease in efficiency of hole injection in the P-GaN island structure and further a decrease in a compensation effect of the electron trap. An excessively small spacing distance results in an increase in the intrinsic on-resistance of the device, a decrease in performance of the device, and an increase in use costs of the device.

### Embodiment 1

Embodiment 1 of this application provides a gallium nitride device, to reduce a risk of an increase in an intrinsic on-resistance of the device while ensuring efficiency of hole injection at P-GaN.

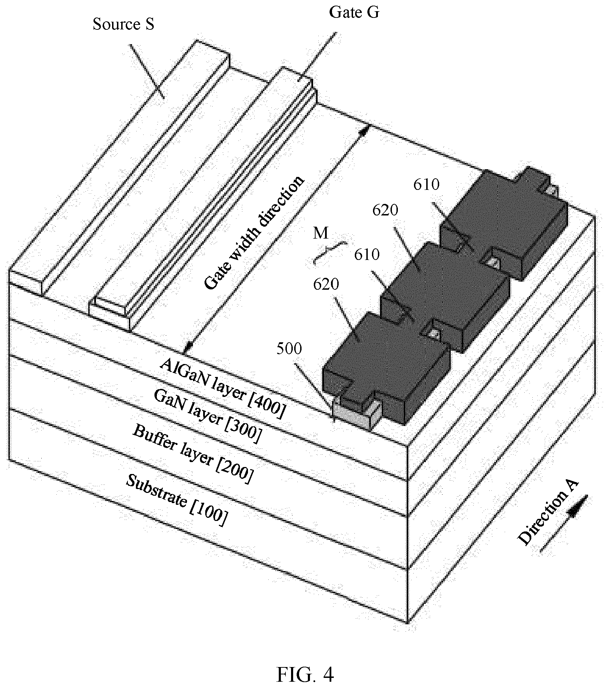

FIG. 4 is a three-dimensional view of a gallium nitride device according to Embodiment 1 of this application. As shown in FIG. 4, the gallium nitride device includes: a substrate (substrate) 100; a buffer layer (buffer layer) 200 formed over the substrate 100; a gallium nitride GaN layer 300 formed over the buffer layer 200; an aluminum gallium nitride AlGaN layer 400 formed over the gallium nitride GaN layer 300; and a source (source, S), a drain (drain, D), and a gate (gate, G) formed on the AlGaN layer 400. The drain (drain, D) includes a P-GaN layer 500 formed on the AlGaN layer 400, and a drain metal M disposed on the P-GaN layer 500 and on the AlGaN layer 400 that is on two sides of the P-GaN layer 500. The drain metal M may be an ohmic metal.

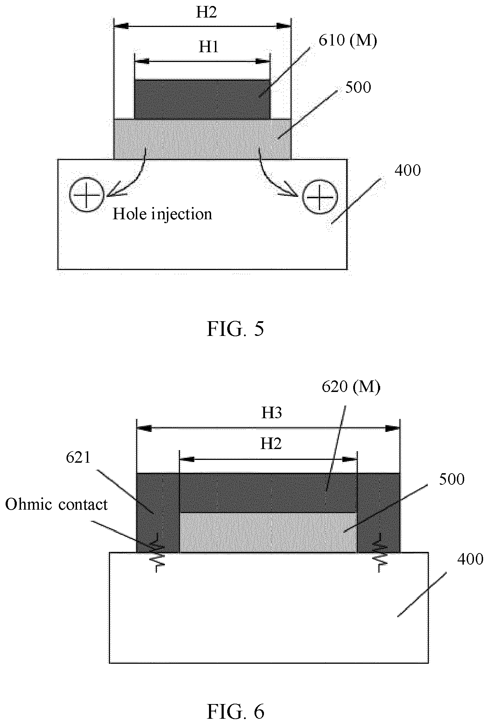

In specific implementation, the P-GaN layer 500 is of a strip structure. Preferably, the P-GaN layer 500 has a same width in all positions in a gate width direction. The drain metal M may include a plurality of first structural intervals 610 and a plurality of second structural intervals 620 in the gate width direction. The plurality of first structural intervals 610 and the plurality of second structural intervals 620 are alternately distributed in the gate width direction. The plurality of first structural intervals 610 and the plurality of second structural intervals 620 are an integrated structure in the gate width direction. FIG. 5 is a view of a partial section of a first structural interval 610 in a direction A according to Embodiment 1 of this application. As shown in FIG. 5, in the first structural interval 610, the drain metal M is formed on the P-GaN layer 500. Preferably, a width H1 of the drain metal M in a direction perpendicular to the gate width direction is less than or equal to a width H2 of the P-GaN layer 500, so that the drain metal M is in contact with only the P-GaN layer 500 but not with the AlGaN layer 400. In this way, the first structural interval 610 can implement local injection of holes.

FIG. 6 is a view of a partial section of a second structural interval 620 in a direction A according to Embodiment 1 of this application. As shown in FIG. 6, in the second structural interval 620, the drain metal M is formed on the P-GaN layer 500 and on the AlGaN layer 400 that is on the two sides of the P-GaN layer 500. A width H3 of the drain metal M in a direction perpendicular to the gate width direction is greater than a width H2 of the P-GaN layer 500. In this case, on each side of the P-GaN layer 500, the drain metal M has a portion that is located outside a width range of the P-GaN layer 500, forming an extension portion 621. A portion of the drain metal located on the P-GaN layer 500 is in contact with the P-GaN layer 500, and the extension portions 621 of the drain metal M are directly formed on the AlGaN layer 400 and form ohmic contact (Ohmic contact) with the AlGaN layer 400. In this way, the second structural interval 620 can implement current conduction from the drain D to the source S of the device being in an operating state.

Further, it can be learned with reference to FIG. 6 that in the second structural interval 620, a section of the drain metal M may exhibit a concave structure, which snaps on the P-GaN layer 500. The drain metal M encloses the P-GaN layer 500 between the drain metal M and the AlGaN layer 400 by using the concave structure. Portions of the concave structure on two sides are the extension portions 621, and a middle portion of the concave structure is the portion formed on the P-GaN layer 500.

In this embodiment of this application, that the first structural intervals 610 and the second structural intervals 620 are alternately distributed in the gate width direction means that in the gate width direction, one second structural interval 620 is disposed between any two adjacent first structural intervals 610, and one first structural interval 610 is disposed between any two adjacent second structural intervals 620, so that the plurality of first structural intervals 610 and the plurality of second structural intervals 620 can be evenly distributed in the gate width direction. In this way, the gallium nitride device can evenly and alternately form hole injection areas and current conduction areas in the gate width direction, improving consistency in performance of the device at all positions in the gate width direction.

In this embodiment of this application, a quantity of the first structural intervals 610 and a quantity of the second structural intervals 620 may be in a plurality of forms. For example, the quantity of the first structural intervals 610 and the quantity of the second structural intervals 620 may be related to a width of the gate. A larger width of the gate corresponds to a larger quantity of the first structural intervals 610 and a larger quantity of the second structural intervals 620. A smaller width of the gate corresponds to a smaller quantity of the first structural intervals 610 and a smaller quantity of the second structural intervals 620. In this way, regardless of the width of the gate, there is high consistency in performance of the device at all positions in the gate width direction by adjusting the quantity of the first structural intervals 610 and the quantity of the second structural intervals 620.

In this embodiment of this application, a ratio of a length of the first structural interval 610 to a length of the second structural interval 620 in the gate width direction may be in a plurality of forms. A person skilled in the art may determine the ratio based on device performance actually required. For example, to obtain a gallium nitride device with a high concentration of carriers, the length of the first structural interval 610 may be increased; and to improve a gallium nitride device's capability of current conduction from a drain D to a source S, the length of the second structural interval 620 may be increased.

In this embodiment of this application, shapes of the first structural interval 610 and the second structural interval 620 may be in a plurality of forms. For example, the first structural interval 610 and the second structural interval 620 may be rectangular, polygonal, circular, oval, or the like.

According to the foregoing structure, the drain metal M is in contact with only the P-GaN layer 500 in the first structural intervals 610, implementing local injection of holes; and the drain metal M forms ohmic contact (Ohmic contact) with the AlGaN layer 400 in the second structural intervals 620, implementing current conduction from the drain D to the source S of the device being in an operating state. Therefore, a risk of an increase in the intrinsic on-resistance of the device can be reduced while ensuring efficiency of hole injection at P-GaN. In addition, when the gallium nitride device provided in Embodiment 1 of this application is produced, the P-GaN layer 500 does not need to be etched into a discontinuous structure, thereby avoiding an impact of etching precision on performance of the device, and allowing a simpler process.

### Embodiment 2

Embodiment 2 of this application provides a gallium nitride device production method. The method is used to obtain the gallium nitride device provided in Embodiment 1 of this application or another gallium nitride device.

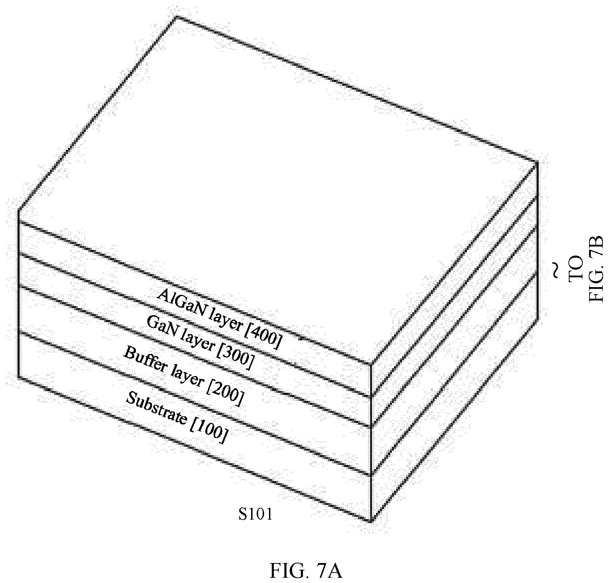

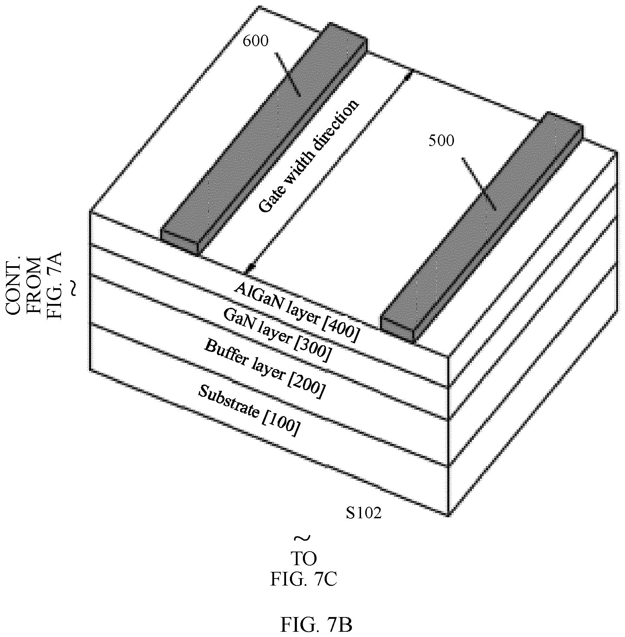

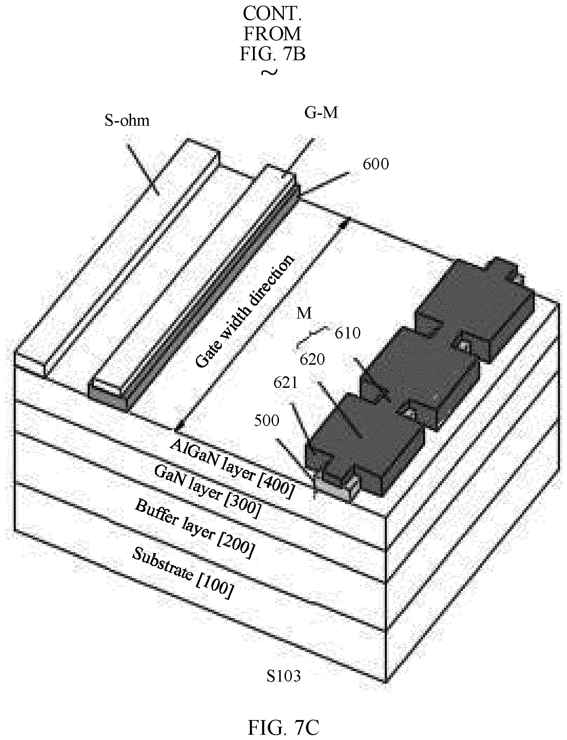

FIG. 7A, FIG. 7B, and FIG. 7C are a flowchart of a gallium nitride device production method according to Embodiment 2 of this application. As shown in FIG. 7A, FIG. 7B, and FIG. 7C, the method may include the following steps.

Step S101: Epitaxially grow a buffer layer 200, a GaN layer 300, and an AlGaN layer 400 sequentially from bottom to top on a substrate 100.

Step S101 is a conventional step of producing a gallium nitride device and is not further elaborated in this embodiment of this application.

Step S102: Etch a P-GaN layer 500 of a drain D on the AlGaN layer 400, where the P-GaN layer 500 is of a continuous strip structure in a gate width direction.

A step of etching a P-GaN layer 600 of a gate G on the AlGaN layer 400 may also be implemented in step S102. Etching the P-GaN layer 600 of the gate G on the AlGaN layer 400 is a conventional step of producing a gallium nitride device and is not further elaborated in this embodiment of this application.

Step S103: Produce a drain metal M on the P-GaN layer 500 and the AlGaN layer 400 that is located on two sides of the P-GaN layer 500.

The drain metal M includes a plurality of first structural intervals 610 and a plurality of second structural intervals 620 in the gate width direction. The first structural intervals 610 and the second structural intervals 620 are continuously and alternately distributed in the gate width direction.

In the first structural intervals 610, the drain metal M is etched only on the P-GaN layer 500. Preferably, a width of the drain metal M in a direction perpendicular to the gate width direction is less than or equal to a width of the P-GaN layer 500, so that the drain metal M is in contact with only the P-GaN layer 500 but not with the AlGaN layer 400. In the second structural intervals 620, on each side of the P-GaN layer 500, the drain metal M has a portion that is located outside a width range of the P-GaN layer 500, forming an extension portion 621. The extension portions 621 of the drain metal M are directly formed on the AlGaN layer 400 and form ohmic contact (Ohmic contact) with the AlGaN layer 400.

In addition, a step of growing a source metal S-ohm on the AlGaN layer 400 and a step of growing a gate metal G-M on the P-GaN layer 600 of the gate G may also be implemented in step S103. Growing the source metal S-ohm on the AlGaN layer 400 and growing the gate metal G-M on the P-GaN layer 600 of the gate G are both conventional steps of producing a gallium nitride device and are not further elaborated in this embodiment of this application.

It can be learned with reference to FIG. 7A, FIG. 7B, and FIG. 7C that when the gallium nitride device provided in Embodiment 1 of this application is produced, it is only necessary to generate the continuous strip P-GaN layer 500 by etching on the AlGaN layer 400, and it is not necessary to precisely etch the P-GaN layer 500 into P-GaN islands, thereby allowing a simple process and helping improve a good ratio and production efficiency of the devices.

### Embodiment 3

Embodiment 3 of this application provides a gallium nitride device, to reduce a risk of an increase in an intrinsic on-resistance of the device while ensuring efficiency of hole injection at P-GaN.

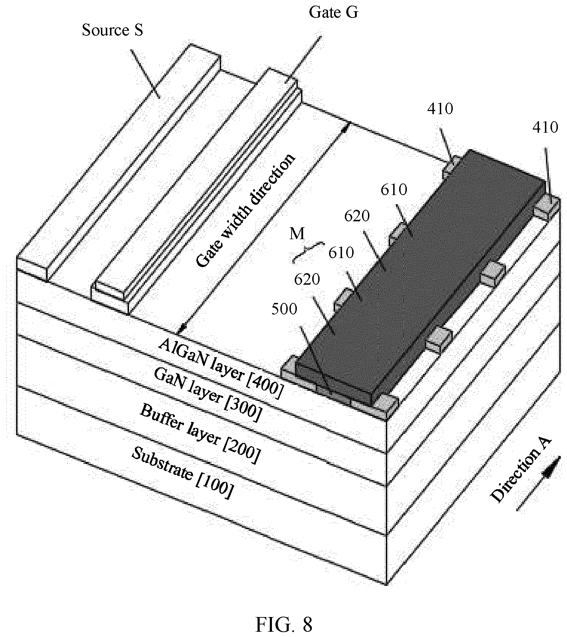

FIG. 8 is a three-dimensional view of a gallium nitride device according to Embodiment 3 of this application. As shown in FIG. 8, the gallium nitride device includes: a substrate (substrate) 100; a buffer layer 200 formed over the substrate 100; a gallium nitride GaN layer 300 formed over the buffer layer 200; an aluminum gallium nitride AlGaN layer 400 formed over the gallium nitride GaN layer 300; and a source (source, S), a drain (drain, D), and a gate (gate, G) formed on the AlGaN layer 400. The drain (drain, D) includes a P-GaN layer 500 formed on the AlGaN layer 400, and a drain metal M disposed on the P-GaN layer 500 and on the AlGaN layer 400 that is on two sides of the P-GaN layer 500.

In specific implementation, the P-GaN layer 500 is of a strip structure. Preferably, the P-GaN layer 500 has a same width in all positions in a gate width direction. The drain metal M may include a plurality of first structural intervals 610 and a plurality of second structural intervals 620 in the gate width direction. The first structural intervals 610 and the second structural intervals 620 are alternately distributed in the gate width direction.

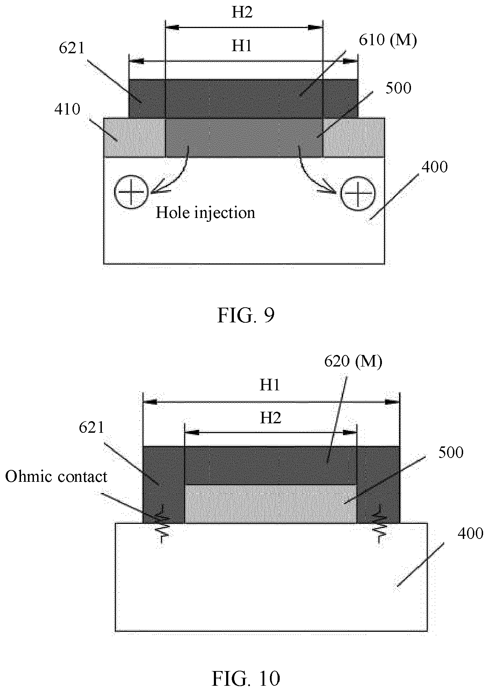

FIG. 9 is a view of a partial section of a first structural interval 610 according to Embodiment 3 of this application. As shown in FIG. 9, in the first structural interval 610, the drain metal M is formed on the P-GaN layer 500 and on the AlGaN layer 400 that is on the two sides of the P-GaN layer 500. A width H1 of the drain metal M in a direction perpendicular to the gate width direction is greater than a width H2 of the P-GaN layer 500. In this case, on each side of the P-GaN layer 500, the drain metal M has a portion that is located outside a width range of the P-GaN layer 500, forming an extension portion 621. A portion of the drain metal M located on the P-GaN layer 500 is in contact with the P-GaN layer 500. In areas on a surface of the AlGaN layer 400 and under the extension portions 621, passivation layers 410 are retained. The extension portions 621 of the drain metal M are formed on the passivation layers 410, and are in contact with only the passivation layers 410 but not with the AlGaN layer 400, isolating the drain metal M from the AlGaN layer 400. In this way, the first structural interval 610 can implement local injection of holes. In addition, the P-GaN layer 500 in the first structural interval 610 may further function as a drain field plate. In this case, while implementing local injection of holes, the first structural interval 610 has a capability of balancing a high-voltage electric field at the drain, improving performance of the device.

FIG. 10 is a view of a partial section of a second structural interval 620 according to Embodiment 3 of this application. As shown in FIG. 10, in the second structural interval 620, similar to that in the first structural interval 610, the drain metal M is formed on the P-GaN layer 500 and on the AlGaN layer 400 that is on the two sides of the P-GaN layer 500. A width H1 of the drain metal M in the direction perpendicular to the gate width direction is greater than a width H2 of the P-GaN layer 500. In this case, on each side of the P-GaN layer 500, the drain metal M has a portion that is located outside a width range of the P-GaN layer 500, forming an extension portion 621. A portion of the drain metal M located on the P-GaN layer 500 is in contact with the P-GaN layer 500. In areas on a surface of the AlGaN layer 400 and under the extension portions 621, passivation layers 410 are not retained, that is, the passivation layers 410 are removed by etching. In this case, the extension portions 621 of the drain metal M are directly formed on the AlGaN layer 400 and form ohmic contact (Ohmic contact) with the AlGaN layer 400. In this way, the second structural interval 620 can implement current conduction from the drain D to the source S of the device being in an operating state.

In a preferred implementation, the width of the drain metal M in the first structural interval 610 is the same as the width H1 of the drain metal M in the second structural interval 620, to reduce a difficulty of a process and facilitate production.

Further, it can be learned with reference to FIG. 9 and FIG. 10 that in both the first structural interval 610 and the second structural interval 620, a section of the drain metal M may exhibit a concave structure, which snaps on the P-GaN layer 500. The drain metal M encloses the P-GaN layer 500 by using the concave structure. Portions of the concave structure on two sides are the extension portions 621, and a middle portion of the concave structure is the portion that is in contact with the P-GaN layer 500.

According to the foregoing structure, the drain metal M is in contact with only the P-GaN layer 500 in the first structural intervals 610, implementing local injection of holes; and the drain metal M forms ohmic contact (Ohmic contact) with the AlGaN layer 400 in the second structural intervals 620, implementing current conduction from the drain D to the source S of the device being in an operating state. Therefore, a risk of an increase in the intrinsic on-resistance of the device can be reduced while ensuring efficiency of hole injection at P-GaN. In addition, when the gallium nitride device provided in Embodiment 3 of this application is produced, the P-GaN layer 500 does not need to be etched into a discontinuous structure, thereby avoiding an impact of etching precision on performance of the device, and allowing a simpler process. In addition, the P-GaN layer 500 in the first structural interval 610 may further function as a drain field plate. In this case, while implementing local injection of holes, the first structural interval 610 has a capability of balancing a high-voltage electric field at the drain, improving performance of the device.

### Embodiment 4

Embodiment 4 of this application provides a gallium nitride device production method. The method is used to obtain the gallium nitride device provided in Embodiment 3 of this application or another gallium nitride device.

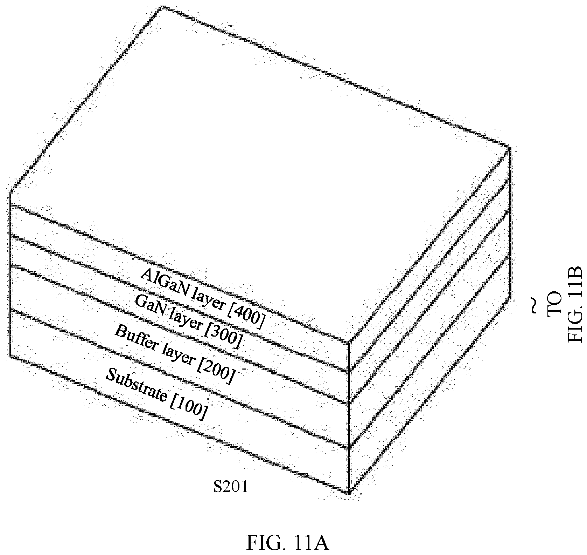

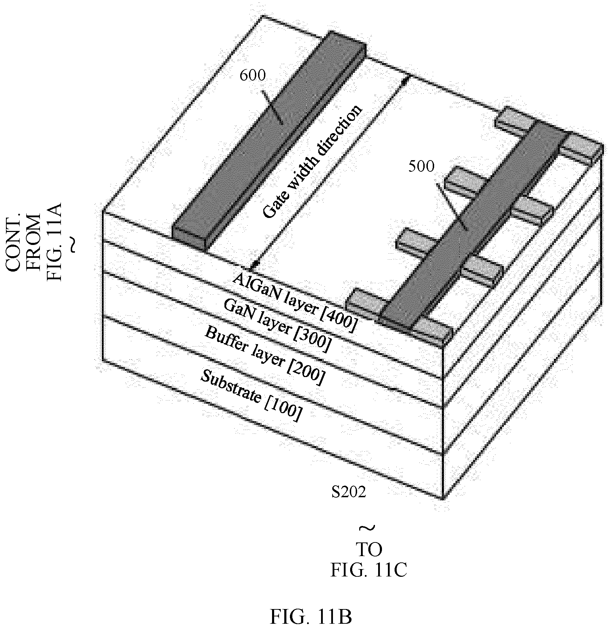

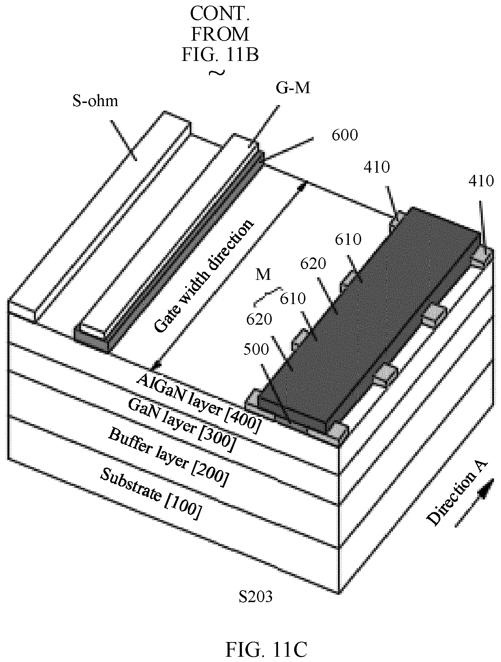

FIG. 11A, FIG. 11B, and FIG. 11C are a flowchart of a gallium nitride device production method according to Embodiment 4 of this application. As shown in FIG. 11A, FIG. 11B, and FIG. 11C, the method may include the following steps.

Step S201: Epitaxially grow a buffer layer 200, a GaN layer 300, and an AlGaN layer 400 sequentially from bottom to top on a substrate 100.

Step S201 is a conventional step of producing a gallium nitride device and is not further elaborated in this embodiment of this application.

Step S202: Etch a P-GaN layer 500 of a drain D on the AlGaN layer 400, where the P-GaN layer 500 of the drain D may be of a strip structure continuously generated in a gate width direction.

When the P-GaN layer 500 is etched, passivation layers 410 in areas on two sides of the P-GaN layer 500 may be retained at specific intervals in the gate width direction, that is, the passivation layers 410 may be removed by etching at intervals.

In addition, a step of etching a P-GaN layer 600 of a gate G on the AlGaN layer 400 may also be implemented in step S202. Etching the P-GaN layer 600 of the gate G on the AlGaN layer 400 is a conventional step of producing a gallium nitride device and is not further elaborated in this embodiment of this application.

Step S203: Produce a drain metal M on the P-GaN layer 500 and the AlGaN layer 400 that is located on the two sides of the P-GaN layer 500.

The drain metal M may be continuously distributed in the gate width direction.

A width of the drain metal M is greater than a width of the P-GaN layer 500. In this case, on each side of the P-GaN layer 500, the drain metal M has a portion that is located outside a width range of the P-GaN layer 500, forming an extension portion 621. Because the passivation layers 410 in the areas on the two sides of the P-GaN layer 500 are in different etching states, the drain metal M may include a plurality of first structural intervals 610 and a plurality of second structural intervals 620 in the gate width direction. The first structural intervals 610 and the second structural intervals 620 are continuously and alternately distributed in the gate width direction.

In areas in which the passivation layers 410 are retained (that is, areas in which the passivation layers 410 are not removed by etching), the drain metal M forms the first structural interval 610. In the first structural interval 610, a portion of the drain metal M located on the P-GaN layer 500 is in contact with the P-GaN layer 500; and the extension portions 621 of the drain metal M are formed on the passivation layers 410, and are in contact with only the passivation layers 410 but not with the AlGaN layer 400.

In areas in which the passivation layers 410 are etched (that is, areas in which the passivation layers 410 are removed), the drain metal M forms the second structural interval 620. In the second structural interval 620, a portion of the drain metal M located on the P-GaN layer 500 is in contact with the P-GaN layer 500; and the extension portions 621 of the drain metal M are directly formed on the AlGaN layer 400 and form ohmic contact (Ohmic contact) with the AlGaN layer 400.

In addition, a step of growing a source metal S-ohm on the AlGaN layer 400 and a step of growing a gate metal G-M on the P-GaN layer 600 of the gate G may also be implemented in step S203. Growing the source metal S-ohm on the AlGaN layer 400 and growing the gate metal G-M on the P-GaN layer 600 of the gate G are both conventional steps of producing a gallium nitride device and are not further elaborated in this embodiment of this application.

It can be learned with reference to FIG. 11A, FIG. 11B, and FIG. 11C that when the gallium nitride device provided in Embodiment 3 of this application is produced, it is only necessary to generate the continuous strip P-GaN layer 500 by etching on the AlGaN layer 400, and it is not necessary to precisely etch the P-GaN layer 500 into P-GaN islands, thereby allowing a simple process and helping improve a good ratio and production efficiency of the devices.

### Embodiment 5

Embodiment 5 of this application provides a gallium nitride device.

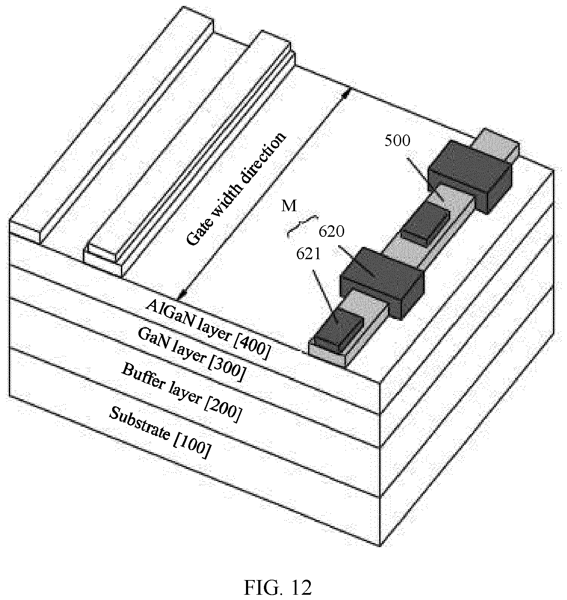

FIG. 12 is a three-dimensional view of a structure of the gallium nitride device according to Embodiment 5 of this application. In comparison with FIG. 4, it can be learned from FIG. 12 that a difference between the gallium nitride device provided in Embodiment 5 of this application and the gallium nitride device provided in Embodiment 1 lies in that: first structural intervals 610 and second structural intervals 620 in a drain metal M are alternately distributed rather than continuously distributed in a gate width direction, and there is specific spacing between a first structural interval 610 and a second structural interval 620 that are adjacent. For remaining features that are not specifically described in Embodiment 5 of this application, refer to implementation of Embodiment 1 of this application. Details are not described herein again.

An embodiment of this application further provides an electronic device. The electronic device may be, for example, a power adapter, a rectifier, an inverter, a frequency converter, a server, a remote radio unit (remote radio unit, RRU), or a switching power supply. The electronic device may include one or more gallium nitride devices provided in embodiments of this application.

An embodiment of this application further provides a drive circuit including a gate driver and the gallium nitride device according to the first aspect and the implementations of the first aspect in the embodiments of this application.

A gate of the gallium nitride device is coupled to a signal output terminal of the gate driver, and a source and a drain of the gallium nitride device are coupled into a load circuit. The gate driver is configured to output a first potential to turn on the gallium nitride device, and output a second potential to turn off the gallium nitride device, where the first potential is higher than a turn-on potential of the gallium nitride device, and the second potential is lower than the turn-on potential of the gallium nitride device.

Usually, the gallium nitride device uses the gate for controlling, and electrical signals of different potentials are input to the gate, to control an on/off state of the gallium nitride device. When the electrical signal input to the gate is higher than a critical potential, the gallium nitride device is turned on. When the electrical signal input to the gate is lower than the potential, the gallium nitride device is turned off. The critical potential may be referred to as the turn-on potential of the gallium nitride device. In this embodiment of this application, the first potential output by the gate driver may also be referred to as a high potential. Because the first potential is higher than the turn-on potential, the gallium nitride device may be turned on. The second potential output by the gate driver may also be referred to as a low potential. Because the second potential is lower than the turn-on potential, the gallium nitride device may be turned off, thereby implementing state control of the gallium nitride device.

In this way, the gallium nitride device may be used as a switching device in the load circuit, and is controlled to be on and off by the gate driver. Because the gallium nitride device overcomes a "current collapse" effect and has a small intrinsic on-resistance and a small device loss, overall operating efficiency of the load circuit can be improved, a total amount of heat generated by the load circuit can be reduced, and operating stability of the load circuit can be improved. It is easy to understand that a person skilled in the art may obtain other embodiments by combining, splitting, or reassembling embodiments of this application based on the several embodiments provided in this application, and these embodiments do not go beyond the protection scope of this application.

The objectives, technical solutions, and benefits of the present invention are further described in detail in the foregoing specific embodiments. It should be understood that the foregoing description is merely specific embodiments of the present invention, but is not intended to limit the protection scope of the present invention.

## Claims

1. Agallium nitride device production method, used for producing a gallium nitride device comprising a substrate (100); a buffer layer (200) formed over the substrate (100) ; a gallium nitride, GaN layer (300) formed over the buffer layer (200); an AlGaN layer (400) formed over the gallium nitride, GaN layer (300); and a source (S), a drain (D), and a gate (G) that are formed on the AlGaN layer (400), wherein the drain (D) comprises a P-GaN layer (500) and a drain metal (M), wherein the method comprises:
epitaxially growing the buffer layer (200), the GaN layer (300), and the AlGaN layer (400) sequentially from bottom to top on the substrate (100);
etching the P-GaN layer (500) on the AlGaN layer (400), wherein the P-GaN layer (500) is of a strip structure in a gate width direction; and
producing the drain metal (M) on the P-GaN layer (500) and the AlGaN layer (400) that is located on two sides of the P-GaN layer (500), so that the drain metal (M) has a plurality of first structural intervals (610) and a plurality of second structural intervals (620) that are alternately distributed in the gate width direction, wherein in the first structural intervals (610), the drain metal (M) is in contact with the P-GaN layer (500) but not with the AIGaN layer, and in the second structural intervals (620), the drain metal (M) is in contact with the P-GaN layer (500) and forms ohmic contact with the AlGaN layer (400).

2. The method according to claim 1, wherein the first structural intervals (610) are obtained by using the following method:
etching the drain metal (M) on the P-GaN layer (500), wherein a width of the drain metal (M) in a direction perpendicular to the gate width direction is less than or equal to a width of the P-GaN layer (500), to form the first structural intervals (610).

3. The method according to claim 1, wherein the second structural intervals (620) are obtained by using the following method:
etching the drain metal (M) on the P-GaN layer (500) and the AlGaN layer (400) that is located on the two sides of the P-GaN layer (500), wherein the drain metal (M) comprises extension portions located on the two sides of the P-GaN layer (500), and the extension portions form ohmic contact with the AlGaN layer (400), to form the second structural intervals (620).

4. The method according to claim 1,
wherein the first structural intervals (610) and the second structural intervals (620) are obtained by using the following method:
performing etching removal, at intervals in the gate width direction, of passivation layers that are in areas on the two sides of the P-GaN layer (500); and
etching the drain metal (M) on the P-GaN layer (500) and the AlGaN layer (400) that is located on the two sides of the P-GaN layer (500), wherein the drain metal (M) comprises extension portions located on the two sides of the P-GaN layer (500), wherein
in areas in which the passivation layers are not removed by etching, the extension portions are isolated from the AlGaN layer (400) by the passivation layers, to form the first structural intervals (610), and in areas in which the passivation layers are removed by etching, the extension portions are in contact with the AlGaN layer (400), to form the second structural intervals (620).

## Patentansprüche

1. Verfahren zur Herstellung einer Galliumnitrid-Vorrichtung, das zur Herstellung einer Galliumnitrid-Vorrichtung verwendet wird, umfassend ein Substrat (100); eine Pufferschicht (200), die über dem Substrat (100) gebildet ist; eine Galliumnitrid (GaN)-Schicht (300), die über der Pufferschicht (200) gebildet ist; eine AlGaN-Schicht (400), die über der Galliumnitrid (GaN)-Schicht (300) gebildet ist; und eine Source (S), ein Drain (D) und ein Gate (G), die auf der AlGaN-Schicht (400) gebildet sind, wobei das Drain (D) eine P-GaN-Schicht (500) und ein Drain-Metall (M) umfasst, wobei das Verfahren Folgendes umfasst:
epitaktisches Wachsen der Pufferschicht (200), der GaN-Schicht (300) und der AlGaN-Schicht (400) nacheinander von unten nach oben auf dem Substrat (100);
Ätzen der P-GaN-Schicht (500) auf die AlGaN-Schicht (400), wobei die P-GaN-Schicht (500) in einer Gate-Breitenrichtung eine Streifenstruktur aufweist; und
Herstellen des Drain-Metalls (M) auf der P-GaN-Schicht (500) und der AlGaN-Schicht (400), die sich auf zwei Seiten der P-GaN-Schicht (500) befindet, so dass das Drain-Metall (M) eine Vielzahl von ersten Strukturintervallen (610) und eine Vielzahl von zweiten Strukturintervallen (620) aufweist, die abwechselnd in Gate-Breitenrichtung angeordnet sind, wobei in den ersten Strukturintervallen (610) das Drain-Metall (M) in Kontakt mit der P-GaN-Schicht (500), jedoch nicht mit der AlGaN-Schicht, steht und in den zweiten Strukturintervallen (620) das Drain-Metall (M) mit der P-GaN-Schicht (500) in Kontakt steht und einen ohmschen Kontakt mit der AlGaN-Schicht (400) bildet.

2. Verfahren nach Anspruch 1, wobei die ersten Strukturintervalle (610) unter Verwendung des folgenden Verfahrens erlangt werden: Ätzen des Drain-Metalls (M) auf die P-GaN-Schicht (500), wobei eine Breite des Drain-Metalls (M) in einer Richtung senkrecht zu der Gate-Breitenrichtung kleiner oder gleich einer Breite der P-GaN-Schicht (500) ist, um die ersten Strukturintervalle (610) zu bilden.

3. Verfahren nach Anspruch 1, wobei die zweiten Strukturintervalle (620) unter Verwendung des folgenden Verfahrens erlangt werden: Ätzen des Drain-Metalls (M) auf die P-GaN-Schicht (500) und die AlGaN-Schicht (400), die sich auf den beiden Seiten der P-GaN-Schicht (500) befindet, wobei das Drain-Metall (M) Erweiterungsabschnitte umfasst, die sich auf den beiden Seiten der P-GaN-Schicht (500) befinden, und die Erweiterungsabschnitte einen ohmschen Kontakt mit der AlGaN-Schicht (400) bilden, um die zweiten Strukturintervalle (620) zu bilden.

4. Verfahren nach Anspruch 1, wobei die ersten Strukturintervalle (610) und die zweiten Strukturintervalle (620) unter Verwendung des folgenden Verfahrens erlangt werden:
Durchführen einer Ätzentfernung in Intervallen in der Gate-Breitenrichtung von Passivierungsschichten, die sich in Bereichen auf den beiden Seiten der P-GaN-Schicht (500) befinden; und
Ätzen des Drain-Metalls (M) auf die P-GaN-Schicht (500) und die AlGaN-Schicht (400), die sich auf den beiden Seiten der P-GaN-Schicht (500) befindet, wobei das Drain-Metall (M) Erweiterungsabschnitte umfasst, die sich auf den beiden Seiten der P-GaN-Schicht (500) befinden, wobei in den Bereichen, in denen die Passivierungsschichten nicht durch Ätzen entfernt werden, die Erweiterungsabschnitte durch die Passivierungsschichten von der AlGaN-Schicht (400) isoliert werden, um die ersten Strukturintervalle (610) zu bilden, und in den Bereichen, in denen die Passivierungsschichten durch Ätzen entfernt werden, die Erweiterungsabschnitte in Kontakt mit der AlGaN-Schicht (400) stehen, um die zweiten Strukturintervalle (620) zu bilden.

## Revendications

1. Procédé de production de dispositif au nitrure de gallium, utilisé pour produire un dispositif au nitrure de gallium comprenant un substrat (100) ; une couche tampon (200) formée sur le substrat (100) ; une couche de nitrure de gallium, GaN (300) formée sur la couche tampon (200) ; une couche d'AlGaN (400) formée sur la couche de nitrure de gallium, GaN (300) ; et une source (S), un drain (D) et une grille (G) qui sont formés sur la couche d'AlGaN (400), dans lequel le drain (D) comprend une couche de P-GaN (500) et un métal de drain (M), dans lequel le procédé comprend :
la croissance épitaxiale de la couche tampon (200), de la couche de GaN (300) et de la couche d'AlGaN (400) séquentiellement de bas en haut sur le substrat (100) ;
l'attaque de la couche de P-GaN (500) sur la couche d'AlGaN (400), dans lequel la couche de P-GaN (500) présente une structure de bande dans une direction de largeur de grille ; et
la production du métal de drain (M) sur la couche de P-GaN (500) et la couche d'AlGaN (400) qui est située sur deux côtés de la couche de P-GaN (500), de sorte que le métal de drain (M) présente une pluralité de premiers intervalles structurels (610) et une pluralité de deuxièmes intervalles structurels (620) qui sont répartis alternativement dans la direction de largeur de grille, dans lequel dans les premiers intervalles structurels (610), le métal de drain (M) est en contact avec la couche de P-GaN (500) mais pas avec la couche d'AlGaN, et dans les deuxièmes intervalles structurels (620), le métal de drain (M) est en contact avec la couche de P-GaN (500) et forme un contact ohmique avec le couche d'AlGaN (400).

2. Procédé selon la revendication 1, dans lequel les premiers intervalles structurels (610) sont obtenus en utilisant le procédé suivant :
l'attaque du métal de drain (M) sur la couche de P-GaN (500), dans lequel une largeur du métal de drain (M) dans une direction perpendiculaire à la direction de largeur de grille est inférieure ou égale à une largeur de la couche de P-GaN (500), pour former les premiers intervalles structurels (610).

3. Procédé selon la revendication 1, dans lequel les deuxièmes intervalles structurels (620) sont obtenus en utilisant le procédé suivant :
l'attaque du métal de drain (M) sur la couche de P-GaN (500) et la couche d'AlGaN (400) qui est située sur les deux côtés de la couche de P-GaN (500), dans lequel le métal de drain (M) comprend des parties d'extension situées sur les deux côtés de la couche de P-GaN (500), et les parties d'extension forment un contact ohmique avec la couche d'AlGaN (400), pour former les seconds intervalles structurels (620).

4. Procédé selon la revendication 1, dans lequel les premiers intervalles structurels (610) et les deuxièmes intervalles structurels (620) sont obtenus en utilisant le procédé suivant :
la réalisation d'une élimination par attaque, à des intervalles dans la direction de largeur de grille, de couches de passivation qui se trouvent dans des zones sur les deux côtés de la couche de P-GaN (500) ; et
l'attaque du métal de drain (M) sur la couche de P-GaN (500) et la couche d'AlGaN (400) qui est située sur les deux côtés de la couche de P-GaN (500), dans lequel le métal de drain (M) comprend des parties d'extension situées sur les deux côtés de la couche de P-GaN (500), dans lequel dans les zones dans lesquelles les couches de passivation ne sont pas éliminées par attaque, les parties d'extension sont isolées de la couche d'AlGaN (400) par les couches de passivation, pour former les premiers intervalles structurels (610), et dans les zones dans lesquelles les couches de passivation sont éliminées par attaque, les parties d'extension sont en contact avec la couche d'AlGaN (400), pour former les deuxièmes intervalles structurels (620).
